# EUROPÄISCHE PATENTSCHRIFT

(11) **EP 0 405 677 B1**
(45) Veröffentlichungstag und Bekanntmachung des Hinweises auf die Patenterteilung: **06.09.1995**
(21) Anmeldenummer: 90201661.7
(22) Anmeldetag: 25.06.1990
(51) Int. Cl.: H01L 39/22, H01L 39/24

(54) **Supraleitendes elektronisches Dünnschichtbauelement und Verfahren zu seiner Herstellung**
Superconducting electronic thin-layer device and method for fabricating the same
Dispositif électronique supraconducteur à couches minces et procédé pour sa fabrication

(30) Priorität: 29.06.1989 DE 3921363
(43) Veröffentlichungstag der Anmeldung: 02.01.1991
(73) Patentinhaber: Philips Patentverwaltung GmbH, 22335 Hamburg (DE); Philips Electronics N.V., 5621 BA Eindhoven (NL)
(72) Erfinder: Häuser, Bernd, Dipl.-Phys., Dr., D-7036 Schönaich (DE); de Nivelle, Martin Jules Marie Emile, NL-7522 NG Enschede (NL); Rogalla, Horst, Prof. Dr., NL-7522 NA Enschede (NL)
(74) Vertreter: Volmer, Georg, Dipl.-Ing.

(56) Entgegenhaltungen:
- EP-A- 0 301 675
- PATENT ABSTRACTS OF JAPAN, Band 13, Nr. 235 (E-766)(3583), 30. Mai 1989 & JP - A - 141281
- APPLIED PHYSICS LETTERS, Band 51, Nr. 18, 2 November 1987, Seiten 1462-1464, New York, NY, US; G.J. CLARK et al.: "Ion beam amorphization of YBa2C30x"
- PATENT ABSTRACTS OF JAPAN, Band 13, Nr. 88 (E-721)(3436), 28. Februar 1989; & JP - A - 63266889

## Beschreibung

Die Erfindung betrifft ein mehrschichtiges elektronisches Dünnschichtbauelement mit Supraleiterschichten auf Basis von einphasigen Erdalkalimetall-dotierten Metall- oder Seltenerdmetalloxocuprat-Mischkristallschichten sowie ein Verfahren zu seiner Herstellung. Insbesondere betrifft sie ein mehrschichtiges elektronisches Dünnschichtbauelement mit Supraleitschichten auf Basis von einphasigen Erdalkalimetall-dotierten Metall- oder Seltenerdmetalloxocuprat-Mischkristallschichten und einer oder mehreren amorphen Isolatorschichten zwischen einzelnen Supraleitschichten und/ oder zwischen einzelnen Supraleitschichten und den im Schichtaufbau sich an diese Supraleitschichten anschließenden Bereiche aus anderen als den supraleitenden Materialien.

Oxidische Supraleiter auf Basis von Erdalkalimetalldotierten Metall- oder Seltenerdmetalloxocupraten erlangen als Hochtemperatur-Supraleiter mit Sprungtemperaturen > 40 K zunehmend Bedeutung für die Realisierung von Dünnschichtbauelementen der elektronischen Informationstechnik.

Für die relativ hohe supraleitende Sprungtemperatur derartiger Mischkristalle wird eine starke Elektron-Phonon--Kopplung verantwortlich gemacht, die optimale Voraussetzungen schafft für die Kopplung der als Träger der Supraleitung wirkenden Elektronen- oder Löcher-Paare.
Dünne Supraleiterschichten werden zur Realisierung sehr unterschiedlicher elektronischer Bauelemente eingesetzt, bekannt sind zum Beispiel analoge oder digitale Bauelemente in Mehrlagentechnik, Bandleitungen, Widerstandselemente, kapazitive Bauelemente, Induktivitätselemente, Tunnelelemente, die den Josephson-Effekt ausnutzen.

Bei diesen Dünnschichtbauelementen ist es erforderlich, die supraleitenden Schichten durch Isolatorschichten voneinander oder von weiteren, am Schichtaufbau beteiligten Bereichen aus anderen Materialien zu isolieren.

Als gute Isolatorschichten haben sich polykristalline Oxidschichten wie Al₂O₃- oder SiO₂-Schichten erwiesen, da in ihnen keine freien Elektronen existieren.

Schwierigkeiten ergeben sich aber z.B. bei Tunnelelementen. Ein Tunnelstrom durch elektrisch isolierende Schichten kann sich nur ergeben, wenn die Isolatorschicht hinreichend dünn ist, damit Einzelelektronen und auch Elektronen- oder Löcher-Paare, deren Energie nicht ausreicht, eine Barriere, wie sie eine Isolatorschicht darstellt, zu überspringen, diese Barriere durchlaufen können. Die Herstellung von homogenen Oxidschichten sehr geringer Dicke ist jedoch nicht ganz einfach. Es bereitet z.B. Schwierigkeiten, derartige Oxidschichten ohne mikroskopische Löcher herzustellen. Deshalb sind in der Praxis auch schon Versuche unternommen worden, die sehr dünnen Oxidschichten durch andere Anordnungen zu ersetzen.

Ein weiteres Problem bei der Herstellung von supraleitenden Dünnschichtbauelementen ist darüberhinaus die Tatsache, daß Grenzflächenphänomene zwischen Isolatorschicht und Supraleiterschicht, z.B. Diffusion von Fremdatomen in die Supraleiterschicht, zu unerwünschten Veränderungen der Übergangstemperatur T_{c} der Supraleiterschicht führen. Bildet sich z.B. eine Oxidschicht auf dem supraleitenden Material, so tritt durch die damit verbundene Änderung der chemischen Struktur des Supraleiters eine unter Umständen starke Änderung der kritischen Temperatur T_{c} des Supraleiters in einer oberflächennahen Schicht ein, die nur durch eine ausreichend große Dicke der Supraleiterschicht kompensiert werden kann.

Um solche unerwünschten Grenzflächenphänomene zu verhindern, ist beispielsweise aus der EP 0 301 675 A2 ein supraleitfähiges Element mit einem Josephson-Tunnelübergang bekannt, das ein Substrat aus einem supraleitfähigen Oxidmaterial, einen isolierenden dünnen Film, eine supraleitende Elektrode auf diesem Film und eine Sperrschicht zwischen dem supraleitenden Substrat und dem isolierenden dünnen Film umfaßt. Die Sperrschicht ist aus einem Metall gemacht, das kaum mit Sauerstoff reagiert und die Wechselwirkung zwischen dem supraleitenden Substrat und dem isolierenden dünnen Film verhindert.

Weiterhin ist aus der JP-A-141281 (=JP-A-6441281) ein Josephsonelement bekannt, das aus einem supraleitenden Oxidfilm, einem amorphen Siliziumfilm oder einem amorphen Siliziumoxid- oder -nitridfilm und einem weiteren supraleitenden Oxidfilm laminiert wird. Diese amorphen, siliziumhaltigen Filme sind jedoch nicht sehr gut gegen Umwelteinflüsse, wie Wasserdampf, beständig.

Es ist auch bekannt, daß in dünnen Schichten des kristallinen Supraleiters YBa₂Cu₃Oₓ, der mit mehreren amorphen oder kristallinen Phasen vermischt ist, durch Ionenimplantation amorphe Zonen an den Korngrenzen der YBa₂Cu₃Oₓ-Kristallite erzeugt werden können. Mit zunehmender Dosis der Bestrahlung werden schließlich die YBa₂Cu₃Oₓ-Kristallite vollständig amorph und elektrisch nichtleitend, während z.B. die Y₂O₃-Phase kristallin bleibt (Appl. Phys. Lett. (18), 2.November 1987,1462-1464).

Der Erfindung liegt die Aufgabe zugrunde, ein mehrschichtiges elektronisches Bauelement mit Supraleitschichten und amorphen Isolatorschichten anzugeben, wobei die Isolatorschichten einerseits eine gute elektrische Isolierung zumindest bei Betriebstemperatur der Bauelemente gewährleisten und darüberhinaus eine sichere Diffusionssperre für Atome aus den Grenzbereichen zwischen isolierten Supraleiterschichten oder den Grenzbereichen zwischen Supraleiterschichten und anderen am Gesamtschichtaufbau beteiligten Materialien bilden sollen. Sie sollen weiterhin Schutz gegenüber Umwelteinflüssen bieten, zum Beispiel also Schutz von Supraleiterschichten gegenüber Einflüssen, die ihre Supraleitfähigkeit beeinträchtigen, wie Verlust von Sauerstoff oder die chemische Zersetzung der Supraleiterschicht unter dem Einfluß von Wasserdampf aus der Atmosphäre.

Diese Aufgabe wird erfindungsgemäß dadurch gelöst, daß die amorphen Isolatorschichten aus den zumindest bei Betriebstemperatur der Bauelemente elektrisch isolierenden, bei den zur Abscheidung der Supraleiterschichten angewendeten Temperaturen noch nicht rekristallisierenden oxidischen Verbindungen Aluminiumoxid oder Aluminiumcuprat bestehen.

Bei Untersuchungen, die der vorliegenden Erfindung zugrundeliegen, hat sich gezeigt, daß polykristalline elektrisch isolierende Oxidschichten, z.B. die bekannten polykristallinen Al₂O₃-Schichten, einen Diffusionsprozeß bei den Temperaturen, die zum Abscheiden weiterer Schichten auf einer bereits auf einer Supraleiterschicht angebrachten polykristallinen Oxidschicht erforderlich sind, nicht nur nicht verhindern sondern noch begünstigen.

Überraschenderweise wurde gefunden, daß amorphe Isolatorschichten aus den zumindest bei Betriebstemperatur der Bauelemente elektrisch isolierenden, bei den zur Abscheidung der Supraleiterschichten angewendeten Temperaturen noch nicht rekristallisierenden oxidischen Verbindungen Aluminiumoxid oder Aluminiumcuprat diesen Effekt nicht zeigen. Darüberhinaus sind sie homogen, d.h. ohne mikroskopische Löcher, auch mit sehr geringen Schichtdicken noch herstellbar.

Besonders amorphes Aluminiumoxid hat den Vorteil, daß es erst bei Temperaturen über 1000 °C rekristallisiert, so daß bei der Abscheidung des supraleitenden Materials mit Substrattemperaturen gearbeitet werden kann, wie sie für die Abscheidung von erdalkalidotierten Metall- oder Seltenerdmetalloxocupratschichten üblich sind (bis etwa 800 °C). Für Anwendungen im Hochfrequenzbereich sind darüberhinaus auch die kleine Dielektrizitätskonstante DK sowie die niedrigen Werte für den Verlustfaktor tan δ von Al₂O₃ von Vorteil.

Wenn Aluminiumcuprat eingesetzt wird, ist damit der Vorteil verbunden, daß Kupferverluste infolge Diffusion aus dem supraleitenden Material im Grenzschichtbereich zur Isolatorschicht vermieden werden.

Nach vorteilhaften Weiterbildungen des erfindungsgemäßen Bauelementes werden für die Supraleiterschichten mit mindestens einem Erdalkalimetall, vorzugsweise Barium, dotierte Yttriumoxocuprate eingesetzt, wobei Yttrium mindestens teilweise durch mindestens ein weiteres Seltenerdmetall substituiert sein kann. Es können für die Supraleiterschichten jedoch auch mit Vorteil mit mindestens einem Erdalkalimetall dotierte Wismutoxocuprate oder Thallium--oxocuprate eingesetzt werden.

Es ist eine weitere Aufgabe der vorliegenden Erfindung, ein einfaches Verfahren zur Herstellung der erfindungsgemäßen Bauelemente anzugeben.

Dabei werden die Supraleiterschichten mittels Hochfrequenz- oder Gleichspannungs-Kathodenzerstäubung bei einer Temperatur im Bereich von etwa 500 °C bis etwa 800 °C in einer sauerstoffhaltigen Atmosphäre abgeschieden. Die Isolatorschichten werden ebenfalls durch Hochfrequenz- oder Gleichspannungs-Kathodenzerstäubung abgeschieden, jedoch bei einer Temperatur, die maximal gleich ist der und die vorzugsweise niedriger ist als die zur Abscheidung der Supraleiterschichten erforderliche Temperatur.

Zur Durchführung dieser Verfahren wird vorteilhafterweise eine Kathodenzerstäubungsanlage eingesetzt, die das Wechseln von Targets während des Beschichtungsprozesses ermöglicht.
Es ist vorteilhaft, einen drehbaren Substrathalter einzusetzen, wobei Magnetron-Kathodenzerstäubungsanlagen besonders geeignet sind und wobei Kontroll- und Regeleinrichtungen für den Druck der Gasatmosphäre und die Substrattemperatur vorgesehen sein sollen.

Das erfindungsgemäße Verfahren kann mit Vorteil eingesetzt werden zur Herstellung von mehrlagigen analogen oder digitalen Bauelementen. Hier ist beispielsweise an die sogenannten SQUID's (Superconducting Quantum Interference Devices) zu denken, die als analoge Bauelemente zur Messung sehr kleiner Magnetfelder eingesetzt werden können, wie sie zum Beispiel durch das Gehirn und das Herz erzeugt werden.
SQUID's können auch als Verstärker oder als digitale Bausteine eingesetzt werden, beispielsweise für logische Verknüpfungen oder als Speicherelemente.

Das erfindungsgemäße Verfahren kann weiter zur Herstellung von Bandleitungen eingesetzt werden.
Verbindungsleitungen in supraleitenden Schaltungen werden als Band- oder Streifenleitungen ausgeführt, die auf einem Substrat mit einer darauf angebrachten Isolatorschicht ausgebildet werden.

Das erfindungsgemäße Verfahren kann jedoch auch zur Herstellung von Widerstandselementen, z.B. Kreuzkryotrons oder Parallelkryotrons, eingesetzt werden.
Hierbei besteht das Substrat, der Schichtträger, beispielsweise aus Einkristallscheiben aus Aluminiumoxid (Saphir), Magnesiumoxid, Zirkondioxid, Strontiumtitanat oder Lithiumniobat. Auf ihm befindet sich zweckmäßigerweise eine supraleitende Grundschicht, die in allen Betriebszuständen des Kryotrons supraleitend bleibt und deshalb hohe kritische Temperaturen T_{c} und hohe kritische Feldstärken aufweisen muß. Zur Isolation der supraleitenden Schicht sind Isolatorschichten aus einem elektrisch isolierenden Material erforderlich. Als aktives Element des Kryotrons wird eine supraleitende, als Torleiter wirksame Schicht angebracht, die bei Betrieb des Kryotrons sowohl den supraleitenden als auch den normalleitenden Zustand annehmen kann. Auf der als Torleiter wirksamen Supraleiterschicht wird wiederum eine Isolatorschicht angebracht, auf der eine als Steuerleiter wirksame weitere supraleitende Schicht angebracht wird.
Der Steuerleiter bleibt bei allen Betriebszuständen des Kryotrons supraleitend und wird daher aus dem gleichen Material hergestellt wie die supraleitende Grundschicht.

Weiter kann das erfindungsgemäße Verfahren zur Herstellung von Induktivitätselementen, wie z.B. Ryotrons oder Kryaktoren, eingesetzt werden.
Ein Ryotron ist ein supraleitendes Bauelement mit einer ausgeprägt nichtlinearen Induktivität. Es besteht aus zwei als Steuerleiter wirksamen supraleitenden Schichten, zwischen denen sich eine als Torleiter wirksame weitere supraleitende Schicht befindet. Die supraleitenden Schichten sind durch Isolatorschichten gegeneinander isoliert. Der Torleiter bleibt bei Betrieb des Ryotrons ständig supraleitend. Seine Induktivitätsänderung erfolgt durch Formung eines ihn umgebenden Magnetfeldes mit Hilfe der Steuerleiter, die den normal- oder den supraleitenden Zustand annehmen können. Im supraleitenden Zustand schränken sie die Ausbildung des durch den Torstrom hervorgerufenen Magnetfeldes ein und verringern somit die Torinduktivität des Ryotrons.
Bei Kryaktoren werden die magnetischen Eigenschaften dünner supraleitender und dünner magnetischer Schichten ausgenutzt. Auf einer supraleitenden Grundschicht befindet sich eine dünne ferromagnetische Schicht, darüber kreuzen sich, wie bei einem Kreuzkryotron, dünne, als Tor- und Steuerleiter wirksame supraleitende Schichten, die gegeneinander elektrisch isoliert sind durch Isolatorschichten. Die als Steuerleiter wirksame supraleitende Schicht ist parallel zur Achse der leichten Magnetisierung der ferromagnetischen Schicht angeordnet, wobei der Magnetisierungsvektor mit Hilfe des Steuerstromes in der Schichtebene gedreht werden kann, was eine Induktivitätsänderung des Torleiters zur Folge hat, ohne daß Steuer- oder Torleiter in den normalleitenden Zustand geschaltet werden. Mit dem Torstrom werden dagegen Magnetfelder gleichsinnig oder entgegengesetzt zur Magnetisierungsrichtung erzeugt. Ein hinreichend großes Magnetfeld entgegengesetzt zur Richtung der leichten Magnetisierung führt den Magnetisierungsvektor in diese ebenfalls stabile Richtung. Auf diese Weise sind zwei definierte Zustände einstellbar, denen die Werte 0 und 1 eines Speicherelementes zugeordnet werden können.

Weiter kann das erfindungsgemäße Verfahren auch für die Herstellung von Tunnelelementen eingesetzt werden. Bauelemente mit zumindest teilweise supraleitenden Elektroden und Einzelelektronentunneln entsprechen den analogen Bauelementen der Halbleitertechnik. Diese Bauelemente können nichtlineare Strom-Spannungs-Kennlinien aufweisen, die über den Aufbau des Schichtpaketes des Tunnelübergangs eingestellt werden. Die Isolatorschicht des Tunnelübergangs hat üblicherweise eine Dicke im Bereich von bis zu einigen 10 nm, die Bandleitungen haben üblicherweise eine Dicke im Bereich von bis zu 300 nm und eine Breite im Bereich von bis zu 500 µm.
Eine Sonderform der Tunnelelemente sind Josephson-Tunnelelemente. Die ausgeprägte Abhängigkeit des Josephson-Stroms vom magnetischen Feld und der Hysteresecharakter der Strom-Spannungs-Kennlinie des Josephson-Übergangs führten zum Aufbau von Bauelementen, die den Kryotrons ähnlich sind. Der Tunnelübergang stellt den nichtlinearen Torleiter dar, der von einem magnetischen Feld gesteuert wird. Im Gegensatz zu den oben genannten Bauelementen bleiben beim Schaltvorgang alle Teile des Josephson-Übergangs supraleitend. Das Tunneln der Elektronen- oder Löcher-Paare durch die bei diesen Bauelementen sehr dünne Isolatorschicht geht bei großen Strömen in das einfache Elektronentunneln über, wodurch am Josephson-Übergang ein Spannungssprung entsteht.

Die mit der Erfindung erzielbaren Vorteile bestehen darin, daß insbesondere sehr dünne Isolatorschichten für supraleitende elektronische Dünnschichtbauelemente hergestellt werden können, die homogen sind und die neben ihrer Wirkung als gute elektrische Isolatoren, insbesondere bei Betriebstemperatur der Bauelemente, noch den Vorzug haben, eine Diffusionsbarriere bei den relativ hohen Temperaturen, bei denen die supraleitenden Schichten üblicherweise abgeschieden werden, zu bilden.
Werden die erfindungsgemäßen Isolatorschichten zum Beispiel auf nichtoxidierten, gegebenenfalls dotierten Silicium-Einkristallsubstraten, wie sie in der Halbleitertechnologie eingesetzt werden, abgeschieden, ergibt sich eine Kombination von Vorteilen: die Isolatorschicht wirkt hier nicht nur als Diffusionssperre und als guter elektrischer Isolator, sondern es wirken sich auch die gegenüber dem Substrat niedrigeren Werte für die Dielektrizitätskonstante DK und die niedrigen Werte für den Verlustfaktor tan δ vorteilhaft aus.
Ein weiterer Vorteil der erfindungsgemäßen amorphen Isolatorschichten im Vergleich zu den bekannten polykristallinen Isolatorschichten ist ihre Morphologie: Amorphe Schichten eignen sich infolge der gegenüber einer Schicht mit polykristalliner Struktur homogeneren Bedeckung der sie tragenden Oberflächen besser zum Schutz dieser Oberflächen gegenüber Umwelteinflüssen, zum Beispiel also als Schutz von Supraleiterschichten gegenüber Einflüssen, die ihre Supraleitfähigkeit beeinträchtigen, wie Verlust von Sauerstoff oder die chemische Zersetzung der Supraleiterschicht unter dem Einfluß von Wasserdampf aus der Atmosphäre.

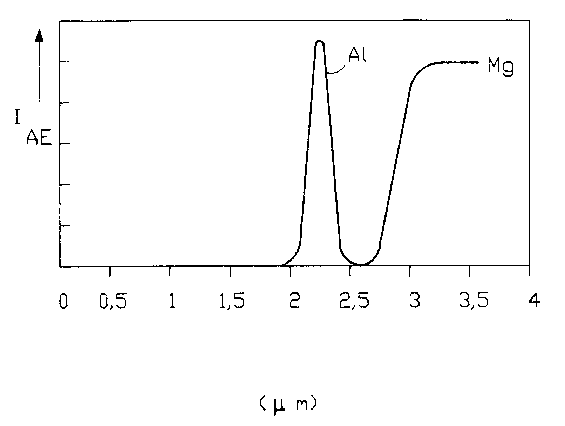

Anhand der Figur wird die Erfindung mit einem Ausführungsbeispiel beschrieben und in ihrer Wirkungsweise erläutert.

Die Figur zeigt ein Auger-Tiefenprofil einer nach dem erfindungsgemäßen Verfahren hergestellten YBa₂CU₃Oₓ - Al₂O₃ - YBa₂Cu₃Oₓ - Schichtenfolge.

Dünne supraleitende Schichten auf Basis von einphasigen YBa₂Cu₃Oₓ-Mischkristallen wurden mittels Hochfrequenzkathodenzerstäubung von keramischen Targets hergestellt. Als Substrat wurden in [100]-Richtung orientierte MgO-Einkristallscheiben eingesetzt.
Zur Herstellung eines Mehrschichtenaufbaus wurden Isolatorschichten aus amorphem Al₂O₃ durch Gleichspannungs-Kathodenzerstäubung auf der Supraleiterschicht erzeugt.

Zur Durchführung des Verfahrens wurde eine Kathodenzerstäubungsanlage eingesetzt, die das Wechseln von Targets während des Beschichtungszyklus ermöglicht. Aus diesem Grund wurde der Substrathalter in der Kathodenzerstäubungsanlage drehbar ausgeführt und es wurde eine Möglichkeit vorgesehen, maximal 4 Targets zu montieren. Der Druck der Zerstäubungsgasatmosphäre und die Substrattemperatur wurden während des Schichtabscheidungsprozesses laufend kontrolliert beziehungsweise geregelt. Als Target für die Isolatorschichten kann sowohl metallisches Aluminium als auch Aluminiumoxid verwendet werden. Im ersteren Fall muß der Kathodenzerstäubungsprozeß in einer reaktiven Gasphase durchgeführt werden, d.h. als Zerstäubungsgas wird reiner Sauerstoff verwendet. Im Fall der Anwendung eines Aluminiumoxidtargets wird zweckmäßigerweise mit einer Inertgas/Sauerstoff-Gasatmosphäre gearbeitet.

Beachtlich für das erfindungsgemäße Verfahren sind insbesondere zwei Maßnahmen:
1. Der gesamte Schichtaufbau (Sandwich), zumindest jedoch eine Schichtenfolge, die mit einer Isolatorschicht abschließt, muß in-situ in der Kathodenzerstäubungsanlage hergestellt werden, um eine Verschlechterung der Oberfläche der als Substrat für die Isolatorschicht wirkenden ersten Supraleiterschicht zu vermeiden. Letzteres tritt z.B. ein, wenn die oxidische Supraleiterschicht entweder mit normaler Atmosphäre in Berührung kommt oder wenn sie sich bei Temperaturen in der Höhe der Abscheidungstemperatur für die Supraleiterschicht in einer sauerstoffarmen Atmosphäre befindet.
2. Die Abscheidung der Isolatorschicht auf der Supraleiterschicht muß bei so niedrigen Temperaturen erfolgen, daß eine amorphe Struktur der zu bildenden Isolatorschicht sichergestellt ist. Dazu kann gegebenenfalls die Temperatur, die zur Abscheidung der Supraleiterschicht erforderlich ist, während des Wachstums der Isolatorschicht abgesenkt werden. Im Fall der Anwendung von Al₂O₃ für die Isolatorschicht ist dies nicht erforderlich, da die Rekristallisationstemperatur von Al₂O₃ ausreichend hoch (über 1000 °C) ist, so daß mit den für die Abscheidung der Supraleiterschicht erforderlichen Temperaturen im Bereich von etwa 500 bis etwa 800 °C gearbeitet werden kann. Eine Rekristallisation des Materials der Isolatorschicht muß vermieden werden, wie vorne bereits ausgeführt wurde, um eine Diffusion von Material der Isolatorschicht in die bereits abgeschiedene Supraleiterschicht, wie sie bei polykristallinen Isolatorschichten auftritt, zu unterbinden.

Die Herstellung der YBa₂Cu₃Oₓ-Supraleiterschicht wurde mit folgenden Parametern durchgeführt:
- Target: YBa₂Cu₃Oₓ, gesintert
- Substrat: MgO, in [100]-Richtung orientert
- Substrattemperatur: 580 bis 600 °C
- Inertgasdruck (z.B. Argon): 6 Pa
- Sauerstoffdruck: 4 Pa
- Leistungsflächendichte: 4 W/cm² Hochfrequenzleistung (13,56 MHz)
- Abscheiderate: 0,07 nm/s
- Schichtdicke: 500 nm.

Die Herstellung der Al₂O₃-Isolatorschicht wurde mit folgenden Parametern durchgeführt:
- Target: Aluminium
- Substrat: MgO, in [100]-Richtung orientiert/supraleitende YBa₂Cu₃Oₓ-Schicht
- Substrattemperatur: 580 bis 600°C
- Inertgasdruck: -
- Sauerstoffdruck: 1,1 Pa
- Leistungsflächendichte: 2 W/cm² Gleichspannungsleistung
- Abscheiderate: 0,035 nm/s
- Schichtdicke: 170 nm.

Mit den oben beschriebenen Parametern konnten elektrisch voneinander isolierte supraleitende Schichten hergestellt werden, wobei die Supraleitfähigkeit beeinträchtigende Diffusionsprozesse zwischen den Schichten nicht auftraten. In der Figur ist ein mittels Auger-Elektronenspektroskopie hergestelltes Tiefenprofil einer nach dem erfindungsgemäßen Verfahren hergestellten YBa₂Cu₃Oₓ-Al₂O₃-YBa₂Cu₃Oₓ-Schichtenfolge dargestellt, wobei die Stromstärke I_{AE} über die Schichtdicke aufgetragen ist. Es ist ersichtlich, daß praktisch keine Diffusion von Isolatorschichtmaterial in die Supraleiterschicht stattgefunden hat. Zu berücksichtigen ist bei der Interpretation oder Flankensteilheit der Kurve, daß dieses Auger-Linienprofil mit einer lateralen Auflösung von 100 nm gemessen wurde.

In dem oben beschriebenen Ausführungsbeispiel ist die Isolatorschicht mit einer Schichtdicke von 170 nm abgeschieden worden. Es ist jedoch möglich, die Schichtdicke der Isolatorschicht an jeweils gewünschte Bedingungen anzupassen und sie kann entsprechend auch in geringeren Schichtdicken abgeschieden werden.

## Patentansprüche

1. Mehrschichtiges elektronisches Dünnschichtbauelement mit Supraleitschichten auf Basis von einphasigen Erdalkalimetall-dotierten Metall- oder Seltenerdmetalloxocuprat-Mischkristallschichten
und einer oder mehreren amorphen Isolatorschichten zwischen einzelnen Supraleitschichten und/ oder zwischen einzelnen Supraleitschichten und den im Schichtaufbau sich an diese Supraleitschichten anschließenden Bereiche aus anderen als den supraleitenden Materialien
dadurch gekennzeichnet, daß
die amorphen Isolatorschichten aus den zumindestens bei Betriebstemperatur der Bauelemente elektrisch isolierenden, bei den zur Abscheidung der Supraleitschichten angewendeten Temperaturen noch nicht rekristallisierenden oxidischen Verbindungen Aluminiumoxid oder Aluminiumcuprat bestehen.

2. Mehrschichtiges elektronisches Dünnschichtbauelement nach Anspruch 1,
dadurch gekennzeichnet,
daß die Supraleitschichten aus mit mindestens einem Erdalkalimetall dotierten Yttriumoxocupraten bestehen, wobei Yttrium mindestens teilweise durch mindestens ein weiteres Seltenerdmetall substituiert sein kann.

3. Mehrschichtiges elektronisches Dünnschichtbauelement nach Anspruch 1,
dadurch gekennzeichnet,
daß die Supraleitschichten aus mit mindestens einem Erdalkalimetall dotierten Wismutoxocupraten bestehen.

4. Mehrschichtiges elektronisches Dünnschichtbauelement nach Anspruch 1,
dadurch gekennzeichnet,
daß die Supraleitschichten aus mit mindestens einem Erdalkalimetall dotierten Thalliumoxocupraten bestehen.

5. Mehrschichtiges elektronisches Dünnschichtbauelement nach Anspruch 2 bis 4,
dadurch gekennzeichnet,
daß das Erdalkalimetall Barium ist.

6. Mehrschichtiges elektronisches Dünnschichtbauelement nach Anspruch 2 bis 4,
dadurch gekennzeichnet,
daß das Erdalkalimetall Calcium ist.

7. Mehrschichtiges elektronisches Dünnschichtbauelement nach Anspruch 1 bis 6,
dadurch gekennzeichnet,
daß das Substrat für den Mehrschichtenaufbau eine in [100]-Richtung orientierte MgO-Einkristallscheibe ist.

8. Verfahren zur Herstellung eines mehrschichtigen elektronischen Dünnschichtbauelementes nach Anspruch 1 bis 7,
dadurch gekennzeichnet,
daß die amorphen Isolatorschichten aus den zumindestens bei Betriebstemperatur der Bauelemente elektrisch isolierende, bei den zur Abscheidung der Supraleitschichten angewendeten Temperaturen noch nicht rekristallisierenden oxidischen Verbindungen, Aluminiumoxid oder Aluminiumcuprat mittels Chemical oder Physical Vapour Deposition hergestellt werden.

9. Verfahren zur Herstellung eines mehrschichtigen elektronischen Dünnschichtbauelementes nach Anspruch 8
dadurch gekennzeichnet,
daß die amorphen Isolatorschichten
durch Hochfrequenz- oder Gleichspannungskathodenzerstäubung bei einer Temperatur abgeschieden werden, die maximal gleich ist der oder die vorzugsweise niedriger ist als die zur Abscheidung der Supraleitschichten erforderliche Temperatur.

10. Verfahren zur Herstellung eines mehrschichtigen elektronischen Dünnschichtbauelementes nach Anspruch 9,
dadurch gekennzeichnet,
daß die amorphen Isolatorschichten
durch Kathodenzerstäubung eines oxidischen Targets in einer Inertgas- oder in einer Inertgas/Sauerstoff-Atmosphäre abgeschieden werden.

11. Verfahren zur Herstellung eines mehrschichtigen elektronischen Dünnschichtbauelementes nach Anspruch 9,
dadurch gekennzeichnet,
daß die amorphen Isolatorschichten
durch reaktive Kathodenzerstäubung eines metallischen Targets in einer sauerstoffhaltigen Atmosphäre abgeschieden werden.

12. Mehrschichtiges elektronisches Dünnschichtbauelement nach Anspruch 1 bis 7,
dadurch gekennzeichnet,
daß es ein analoges oder digitales Bauelement in Mehrlagentechnik, eine Bandleitung, ein Widerstandselement, ein kapazitives Bauelement, ein Induktivitätselement oder ein Tunnelelement ist.

## Claims

1. A multilayer electronic thin-film component comprising superconducting films on the basis of single-phase alkaline earth metal-doped metal oxocuprate mixed-crystal layers or rare earth metal oxocuprate-mixed crystal layers and one or more amorphous insulator layers between individual superconductive films and/or between individual superconductive films and regions of non-superconductive materials adjoining said superconductive films in the layer structure, characterized in that the amorphous insulator layers consist of the oxidic compounds aluminium oxide or aluminium cuprate which are electrically insulating at least at the operating temperature of the components and which do not yet recrystallize at the temperatures used for the deposition of the superconducting films.

2. A multilayer electronic thin-film component as claimed in Claim 1, characterized in that yttrium oxocuprates doped with at least one alkaline earth metal are used for the superconducting films, yttrium possibly being at least partly substituted by at least one further rare earth metal.

3. A multilayer electronic thin-film component as claimed in Claim 1, characterized in that bismuth oxocuprates doped with at least one alkaline earth metal are used for the superconducting films.

4. A multilayer electronic thin-film component as claimed in Claim 1, characterized in that thallium oxocuprates doped with at least one alkaline earth metal are used for the superconducting films.

5. A multilayer electronic thin-film component as claimed in Claims 2 up to and including 4, characterized in that barium is used as the alkaline earth metal.

6. A multilayer electronic thin-film component as claimed in Claims 2 up to and including 4, characterized in that calcium is used as the alkaline earth metal.

7. A multilayer electronic thin-film component as claimed in Claim 1 up to and including 6, characterized in that a [100]-oriented MgO single crystal disc is used as the substrate for the multilayer construction.

8. A method of manufacturing a multilayer electronic thin-film component as claimed in Claims 1 up to and including 7, characterized in that the amorphous insulator layers are manufactured by chemical or physical vapour deposition of the oxidic compounds aluminium oxide or aluminium cuprate which are electrically insulating at least at the operating temperature of the components and which do not yet recrystallize at the temperatures used for the deposition of the superconducting films.

9. A method of manufacturing a multilayer electronic thin-film component as claimed in Claim 8, characterized in that the amorphous insulator layers are deposited by means of high frequency cathode sputtering or direct-voltage cathode sputtering at a temperature which is maximally equal to and preferably lower than the temperature required for the deposition of the superconducting films.

10. A method of manufacturing a multilayer electronic thin-film component as claimed in Claim 9, characterized in that the amorphous insulator layers are deposited by means of cathode sputtering of an oxidic target in an inert gas atmosphere or an inert gas/oxygen atmosphere.

11. A method of manufacturing a multilayer electronic thin-film component as claimed in Claim 9, characterized in that the amorphous insulator layers are deposited by means of reactive cathode sputtering of a metallic target in an oxygen-containing atmosphere.

12. A multilayer electronic thin-film component as claimed in the Claims 1 up to and including 7, characterized in that said component is an analog or digital component manufactured in multilayer technique, a strip line, a resistor, a capacitive component, an inductive element or a tunnel element.

## Revendications

1. Composant électronique à couches multiples du type à couche mince présentant des couches supraconductrices formées sur la base de couches de cristaux mixtes d'oxocuprate de métal de terre rare ou de métal monophasé dopé de métal alcalino-terreux et une ou plusieurs couches d'isolation amorphes formées entre des couches supraconductrices individuelles et/ou entre des couches supraconductrices individuelles et les domaines contigus auxdites couches supraconductrices lors de la formation de la couche et constitués d'autres matériaux que les matériaux supraconducteurs, caractérisé en ce que les couches d'isolation amorphes sont constituées de composés oxydiques d'oxyde d'aluminium ou de cuprate d'aluminium qui sont au moins électriquement isolants à la température de fonctionnement des composants et qui ne recristallisent pas aux températures indispensables au dépôt des couches supraconductrices.

2. Composant électronique à couches multiples du type à couche mince selon la revendication 1, caractérisé en ce que les couches supraconductrices sont constituées d'oxocuprates de yttrium dopés d'au moins un métal alcalino-terreux, au moins le yttrium pouvant être remplacé au moins partiellement par un autre métal de terre rare.

3. Composant électronique à couches multiples du type à couche mince selon la revendication 1, caractérisé en ce que les couches supraconductrices sont constituées d'oxocuprates de tungstène dopés d'au moins un métal alcalino-terreux.

4. Composant électronique à couches multiples du type à couche mince selon la revendication 1, caractérisé en ce que les couches supraconductrices sont constituées d'oxocuprates de thallium dopés d'au moins un métal alcalino-terreux.

5. Composant électronique à couches multiples du type à couche mince selon les revendications 2 à 4, caractérisé en ce que le métal alcalino-terreux est du baryum.

6. Composant électronique à couches multiples du type à couche mince selon les revendications 2 à 4, caractérisé en ce que le métal alcalino-terreux est du calcium.

7. Composant électronique à couches multiples du type à couche mince selon les revendications 1 à 6, caractérisé en ce que le substrat destiné pour la formation de couches multiples est un disque monocristallin en MgO à orientation [100].

8. Procédé pour la fabrication d'un composant électronique à couches multiples du type à couche mince selon les revendications 1 à 7, caractérisé en ce que les couches d'isolation amorphes constituées de composés oxydiques d'oxyde d'aluminium ou de cuprate d'aluminium qui sont au moins électriquement isolants à la température de fonctionnement des composants et qui ne recristallisent pas aux températures indispensables au dépôt des couches supraconductrices sont réalisées par un procédé de métallisation par dépôt chimique ou physique.

9. Procédé pour la fabrication d'un composant électronique à couches multiples du type à couche mince selon la revendication 8, caractérisé en ce que les couches d'isolation amorphes sont déposées par pulvérisation cathodique à courant continu ou à haute fréquence à une température qui est tout au plus égale mais avantageusement inférieure à celle indispensable au dépôt de couches supraconductrices.

10. Procédé pour la fabrication d'un composant électronique à couches multiples du type à couche mince selon la revendication 9, caractérisé en ce que les couches d'isolation amorphes sont déposées par pulvérisation cathodique d'un cible oxidique dans une atmosphère de gaz inerte ou dans une atmosphère renfermant gu gaz inerte et de l'oxygène.

11. Procédé pour la fabrication d'un composant électronique à couches multiples du type à couche mince selon la revendication 9, caractérisé en ce que les couches d'isolation amorphes sont déposées par pulvérisation cathodique réactive d'un cible métallique dans une atmosphère contenant de l'oxygène.

12. Composant électronique à couches multiples du type à couche mince selon les revendications 1 à 7, caractérisé en ce qu'il est un composant analogique ou numérique comportant plusieurs couches, un câble à ruban, un élément de résistance, un composant capacitif, un élément d'inductance ou un élément tunnel.
